# FASCICULE DE BREVET EUROPEEN

(11) **EP 3 148 949 B1**
(45) Date de publication et mention de la délivrance du brevet: **25.07.2018**
(21) Numéro de dépôt: 15732814.7
(22) Date de dépôt: 27.05.2015
(51) Int. Cl.: C03C 17/36

(54) **MATERIAU COMPRENANT UNE COUCHE FONCTIONNELLE A BASE D'ARGENT CRISTALLISEE SUR UNE COUCHE D'OXYDE DE NICKEL**
MATERIAL MIT EINER FUNKTIONELLEN SCHICHT AUS SILBER, KRISTALLISIERT AUF EINER NICKELOXIDSCHICHT
MATERIAL COMPRISING A FUNCTIONAL LAYER MADE FROM SILVER, CRYSTALLISED ON A NICKEL OXIDE LAYER

(30) Priorité: 28.05.2014 FR 1454860
(43) Date de publication de la demande: 05.04.2017
(73) Titulaire: Saint-Gobain Glass France, 92400 Courbevoie (FR)
(72) Inventeur: BROSSARD, Sophie, Minneapolis, Minnesota 55419 (US); MARTIN, Florent, Minneapolis, Minnesota 55419 (US)
(74) Mandataire: Saint-Gobain Recherche
(86) Numéro de dépôt international: PCT/FR2015/051403
(87) Numéro de publication internationale: WO 2015/181500

(56) Documents cités:
- WO-A1-2011/062574
- WO-A2-03/048060
- US-A1- 2002 021 495
- US-A1- 2003 175 529
- US-A1- 2004 241 406
- US-A1- 2009 214 889

## Description

L'invention concerne un matériau et un procédé d'obtention d'un matériau, tel qu'un vitrage, comprenant un substrat transparent revêtu d'un empilement de couches minces comprenant au moins une couche métallique fonctionnelle à base d'argent.

Les couches métalliques fonctionnelles à base d'argent (ou couches d'argent) ont des propriétés de conduction électrique et de réflexion des rayonnements infrarouges (IR) avantageuses, d'où leur utilisation dans des vitrages dits « de contrôle solaire » visant à diminuer la quantité d'énergie solaire entrante et/ou dans des vitrages dits « bas émissifs » visant à diminuer la quantité d'énergie dissipée vers l'extérieur d'un bâtiment ou d'un véhicule.

Ces couches d'argent sont déposées entre des revêtements antireflets qui comprennent généralement plusieurs couches diélectriques permettant d'ajuster les propriétés optiques de l'empilement. Ces couches diélectriques permettent en outre de protéger la couche d'argent des agressions chimiques ou mécaniques.

Les propriétés optiques, électriques et mécaniques des vitrages dépendent directement de la qualité des couches d'argent telle que leur état cristallin, leur homogénéité ainsi que de leur environnement, par exemple de la nature des couches situées au-dessus et en-dessous et de la rugosité de surface des interfaces.

L'invention concerne tout particulièrement un matériau devant subir un traitement thermique à température élevée tel qu'un recuit, un bombage et/ou une trempe. Ces traitements thermiques à haute température provoquent des modifications au sein de la couche d'argent et notamment génèrent des défauts. Certains de ces défauts se présentent sous forme de trou ou de dôme.

Les défauts de type « trou » correspondent à l'apparition de zones dépourvues d'argent, c'est-à-dire à un démouillage partiel de la couche d'argent. Après traitement thermique, la couche d'argent comprend des trous de forme circulaire ou dendritique correspondant à des zones sans argent. La couche d'argent observée au microscope apparait plane. L'épaisseur de cette couche prise au niveau des zones avec argent varie peu.

Les défauts de type « dôme » correspondent à la présence de « gros » grains d'argent générant des variations d'épaisseur au sein de la couche d'argent, c'est-à-dire des zones épaissies et des zones amincies. La variation d'épaisseur peut être ponctuelle, c'est-à-dire observée uniquement au niveau de ces gros grains. La couche d'argent peut alors avoir une épaisseur homogène sauf au niveau de ces gros grains. La variation d'épaisseur peut être plus étendue suite à un réarrangement de la couche d'argent autour de ces gros grains. Ces défauts de type « dôme » ne correspondent pas à un état intermédiaire de défaut de type « trou ». Les documents US 2002/021495 A1, US2003/175529 A1, WO 03/048060 A2, WO 2011/062574 A1, US 2009/214889 A1 et US 2004/241406 A1 divulgue une Low-E structure comprenant un substrat transparent de verre revêtu d'un empilement de couches minces.

Le demandeur a découvert que l'occurrence et le type de défauts, trou ou dôme, sont fonction de la nature des couches diélectriques constituant les revêtements antireflets. Par exemple, la présence d'une couche diélectrique à base d'oxyde d'étain et de zinc dans des revêtements antireflets favorise la formation de défaut de type dôme.

Pour améliorer la qualité des couches métalliques fonctionnelles à base d'argent, il est connu d'utiliser des revêtements antireflets comprenant des couches diélectriques à fonction stabilisante destinées à favoriser le mouillage et la nucléation de la couche d'argent. Des couches diélectriques à base d'oxyde de zinc cristallisé sont notamment utilisées à cette fin. En effet, l'oxyde de zinc déposé par le procédé de pulvérisation cathodique cristallise sans nécessiter de traitement thermique additionnel. La couche à base d'oxyde de zinc peut donc servir de couche de croissance épitaxiale pour la couche d'argent.

Cependant, ces couches d'oxyde de zinc cristallisé situées en-dessous et au-contact d'une couche d'argent présentent deux inconvénients.

D'une part, l'adhésion entre une couche à base d'oxyde de zinc et une couche d'argent est faible. Par conséquent, tous les empilements comprenant la séquence de ces deux couches risquent d'être mécaniquement dégradés et ce a fortiori lorsqu'ils sont soumis à un traitement thermique à température élevée.

D'autre part, une couche d'argent cristallisé par épitaxie sur une couche à base d'oxyde de zinc comprend majoritairement des grains monocristallins d'argent présentant les plans de la famille {111} parallèles à la surface du substrat. Ceci peut être démontré par des analyses par diffraction des rayons X en mode Bragg-Brentano. Dans le cas de l'argent qui cristallise sous la forme d'une structure cubique face centrée, les plans de la famille {111} sont particulièrement denses. De plus, il existe une différence importante entre les paramètres de maille de l'oxyde de zinc cristallisé et de l'argent, notamment de 11%. La croissance par épitaxie de grains monocristallins d'argent sur des grains d'oxyde de zinc engendre la formation de dislocations. Ces dislocations sont autant de défauts ponctuels qui peuvent dégrader la résistivité.

Pour améliorer la qualité des couches métalliques fonctionnelles à base d'argent, il est également connu d'utiliser des couches de blocage dont la fonction est de protéger en évitant une éventuelle dégradation liée au dépôt d'un revêtement antireflet ou liée à un traitement thermique. De nombreuses possibilités variant notamment par la nature, le nombre et la position desdites couches de blocage ont été proposées.

Par exemple, il est possible d'utiliser une couche de blocage ou un revêtement de blocage constitué de plusieurs couches de blocage. Ces couches ou revêtements de blocage peuvent être situés uniquement au-dessus, uniquement en-dessous ou à la fois au-dessus et en-dessous de la couche fonctionnelle.

Le choix de la nature et de l'épaisseur des couches de blocage est fonction des matériaux constituant la couche fonctionnelle, des matériaux constituant les revêtements antireflets situés au contact de la couche fonctionnelle, des éventuels traitements thermiques et des propriétés recherchées.

La complexité des empilements ainsi que la diversité des traitements et propriétés recherchées rendent nécessaire d'adapter les caractéristiques de la couche de blocage à chaque configuration.

Parmi les couches de blocage traditionnellement utilisées, on peut citer les couches de blocage à base d'un métal choisi parmi le niobium Nb, le tantale Ta, le titane Ti, le chrome Cr ou le nickel Ni ou à base d'un alliage obtenu à partir d'au moins deux de ces métaux, notamment d'un alliage de nickel et de chrome (NiCr).

L'utilisation d'une sous-couche de blocage à base d'un alliage de nickel et de chrome permet de limiter l'apparition de flou après traitement thermique de type trempe en limitant la formation de trous ou de dômes dans la couche d'argent. Cependant, la présence de ces couches dégrade l'émissivité, l'absorption de l'empilement et la conductivité en favorisant notamment la diffusion des électrons.

L'utilisation d'une sous-couche de blocage épaisse à base d'oxyde de titane permet de limiter l'apparition de flou après traitement thermique de type trempe sans augmenter significativement l'absorption de l'empilement.

Cependant, ces couches de blocage atténuent l'effet bénéfique lié à la présence d'une couche stabilisante destinée à favoriser la cristallisation de l'argent, telle qu'une couche d'oxyde de zinc, lorsque ces couches de blocages sont intercalées entre la couche stabilisante et la couche d'argent. Dans le cas de la croissance épitaxiale de l'argent sur l'oxyde de zinc, la résistance par carré reste toujours dégradée quel que soit la sous-couche de blocage utilisée.

L'objectif de l'invention est de mettre au point un matériau comprenant un substrat revêtu d'un empilement présentant une résistance mécanique améliorée notamment grâce l'amélioration de l'adhésion des couches d'argent au reste de l'empilement. Avantageusement, ces propriétés doivent être obtenues tout en conservant une faible résistivité.

L'objectif de l'invention est également de mettre au point un matériau comprenant un substrat revêtu d'un empilement destiné à subir à traitement thermique présentant une résistance mécanique et une résistance au flou améliorées, une faible absorption et une faible émissivité.

Les propriétés avantageuses doivent être obtenues même lorsque l'empilement comprend des revêtements antireflets comprenant des couches diélectriques susceptibles de générer des défauts de type dôme dans la couche fonctionnelle à base d'argent.

Le demandeur a découvert que la présence d'une couche mince à base d'oxyde de nickel cristallisé directement au contact de la couche d'argent permet d'obtenir les propriétés avantageuses de l'invention.

Une de caractéristiques essentielles de l'invention repose sur le fait que la couche fonctionnelle à base d'argent est déposée sur une couche à base d'oxyde de nickel préalablement cristallisé. La couche mince à base d'oxyde de nickel cristallisé joue le rôle de couche de croissance et oriente la cristallisation de l'argent selon un plan de la famille {200} par rapport à la surface du substrat.

L'invention concerne un procédé d'obtention d'un matériau comprenant un substrat transparent revêtu d'un empilement de couches minces déposées par pulvérisation cathodique éventuellement assistée par champ magnétique, comprenant au moins une couche métallique fonctionnelle à base d'argent et au moins deux revêtements antireflets, chaque revêtement antireflet comportant au moins une couche diélectrique, de manière à ce que chaque couche métallique fonctionnelle soit disposée entre deux revêtements antireflets, le procédé comporte la séquence d'étapes suivantes :
(a) on dépose un revêtement antireflet comportant au moins une couche mince à base d'oxyde de nickel cristallisé, puis
(b) on dépose au moins une couche métallique fonctionnelle à base d'argent au-dessus et au contact de la couche mince à base d'oxyde de nickel cristallisé.

L'invention concerne également un matériau comprenant un substrat transparent revêtu d'un empilement de couches minces comprenant au moins une couche métallique fonctionnelle à base d'argent, au moins deux revêtements antireflets, chaque revêtement antireflet comportant au moins une couche diélectrique, de manière à ce que chaque couche métallique fonctionnelle soit disposée entre deux revêtements antireflets caractérisé en ce que l'empilement comprend au moins une couche à base d'oxyde de nickel cristallisé située en-dessous et au-contact d'une couche métallique fonctionnelle à base d'argent comprenant plusieurs grains monocristallins orientés de sorte qu'ils aient les plans de la famille {200} parallèles à la surface du substrat.

Le matériau, c'est-à-dire le substrat transparent revêtu de l'empilement, peut être destiné à subir un traitement thermique à température élevée de type trempe, recuit ou bombage.

L'utilisation d'une couche mince à base d'oxyde de nickel cristallisé selon l'invention comme couche de croissance est particulièrement avantageuse dans des empilements susceptibles de générer des défauts de types dômes après traitement thermique à température élevée.

L'utilisation d'une telle couche mince est également particulièrement avantageuse dans des empilements trempables pour lesquels les variations d'émissivité et d'absorption doivent être minimales à la trempe et les niveaux de flou faibles.

La présence d'une couche à base d'oxyde de nickel augmente l'adhésion de la couche d'argent dans l'empilement. L'oxyde de nickel cristallisé présente une structure cristallographique cubique face centrée similaire à la structure cristallographique de l'argent. La différence entre les paramètres de maille de l'oxyde de nickel cristallisé et ceux de l'argent est faible notamment inférieure à 2,2 %. Une couche d'argent cristallisé par épitaxie sur une couche à base d'oxyde de nickel cristallisé comprend majoritairement des grains monocristallins d'argent présentant les plans de la famille {200} parallèles à la surface du substrat. Cette texturation de l'argent selon les plans de la famille {200} sur de l'oxyde de nickel à la place de {111} sur le d'oxyde de zinc semble contribuer à l'obtention des meilleurs résultats en terme d'adhésion.

De plus, la faible différence des paramètres de maille semble également contribuer à diminuer le nombre de dislocations, c'est à dire de défauts ponctuels susceptibles d'altérer la résistance par carré de l'empilement.

La présence de la couche mince à base d'oxyde de nickel cristallisé permet d'obtenir une résistance par carré faible, notamment quasiment égale à celle obtenue dans le cas de la croissance de l'argent sur une couche mince à base d'oxyde de zinc.

La couche mince à base d'oxyde de nickel cristallisé permet d'obtenir une meilleure stabilité thermique et une meilleure adhésion sans dégrader la résistance par carré contrairement à ce qui peut être observé lorsque l'on utilise des couches de blocage entre la couche d'argent et la couche stabilisante.

Par conséquent, l'utilisation d'une couche à base d'oxyde de nickel cristallisé en remplacement total ou partiel d'une couche de croissance à base d'oxyde de zinc cristallisé permet d'améliorer les propriétés mécaniques et chimiques sans nuire aux propriétés électriques de l'empilement.

L'utilisation d'une couche à base d'oxyde de nickel cristallisé au contact de la couche métallique fonctionnelle à base d'argent permet d'empêcher significativement le démouillage et l'apparition de défauts de type dôme dans la couche d'argent lorsque le substrat revêtu de l'empilement est soumis à un traitement thermique de type trempe. La solution de l'invention convient donc tout particulièrement dans le cas de vitrages comprenant un revêtement antireflet comprenant une couche diélectrique susceptible de générer des défauts de type dôme situé en-dessous de la couche métallique fonctionnelle à base d'argent.

Selon un mode de réalisation, le revêtement antireflet situé en-dessous de la couche fonctionnelle à base d'argent comprenant plusieurs grains monocristallins orientés de sorte qu'ils aient la famille de plans {200} parallèles à la surface du substrat comprend une couche diélectrique susceptible de générer des défauts de type dôme choisies parmi les couches à base d'oxyde de zinc et d'étain.

L'invention permet également d'obtenir des performances supérieures, notamment une diminution du flou, de l'absorption dans le visible, de l'émissivité ainsi que de la tenue mécanique de l'empilement complet suite à un traitement thermique. Ces résultats avantageux sont observés notamment par comparaison à ceux obtenus avec des empilements comprenant des couches de blocage, par exemple à base d'alliage de nickel et de chrome ou avec des empilements ne comprenant pas de couche de blocage.

L'oxyde de nickel, contrairement à l'oxyde de zinc, ne cristallise pas à froid dans les conditions de dépôt de la pulvérisation cathodique classique, c'est-à-dire sous vide à température ambiante, sauf si il est déposé sur une couche cristallisée telle qu'une couche d'oxyde de zinc. La combinaison dans l'empilement d'une couche stabilisante d'oxyde de zinc en-dessous d'une couche d'oxyde de nickel permet de cristalliser la couche d'oxyde de nickel et d'obtenir ensuite la cristallisation de l'argent avec des grains monocristallins orientés de sorte qu'ils aient les plans de la famille {200} parallèles à la surface du substrat.

Par conséquent, il est nécessaire d'adapter le procédé de dépôt par pulvérisation cathodique pour cristalliser la couche à base d'oxyde de nickel avant dépôt de la couche d'argent.

La cristallisation de la couche d'oxyde de nickel peut être obtenue par croissance par épitaxie. Pour cela, une couche diélectrique, telle qu'une couche à base d'oxyde de zinc cristallisé, est déposée en-dessous de la couche à base d'oxyde de nickel. Le procédé d'obtention d'un matériau selon l'invention est tel que pendant l'étape (a) :
- on dépose une couche susceptible d'induire une cristallisation par épitaxie telle qu'une couche à base d'oxyde de zinc cristallisé puis
- on dépose au-dessus et au contact une couche à base d'oxyde de nickel.

Selon ce mode de réalisation, le revêtement antireflet situé en-dessous de la couche fonctionnelle à base d'argent comprenant plusieurs grains monocristallins orientés de sorte qu'ils aient la famille de plans {200} parallèles à la surface du substrat comprend une couche diélectrique à fonction stabilisante à base d'oxyde de zinc située au-dessous et au contact de la couche à base d'oxyde de nickel cristallisé.

L'étape de cristallisation peut également être réalisée par une étape de traitement thermique de cristallisation, par exemple par un traitement laser. Dans ce cas, il n'est pas nécessaire que la couche à base d'oxyde de nickel soit déposée au-dessus d'une couche à base d'oxyde de zinc cristallisé.

Cependant, ces deux modes de réalisation sont avantageusement combinés, la réalisation d'un traitement thermique de cristallisation sur une séquence de couches à base d'oxyde de zinc et à base d'oxyde de nickel, avant dépôt de la couche d'argent, permet d'obtenir des résultats encore plus exceptionnels en termes de résistance par carré et d'adhésion de l'empilement.

Le procédé d'obtention d'un matériau selon l'invention est tel que pendant l'étape (a) :
- on dépose une couche à base d'oxyde de nickel cristallisé ou non cristallisé puis
- on soumet la couche mince à base d'oxyde de nickel cristallisé ou non cristallisé à un traitement thermique de cristallisation avant dépôt de la couche métallique fonctionnelle à base d'argent.

L'empilement est déposé par pulvérisation cathodique, notamment assisté par un champ magnétique (procédé magnétron). Chaque couche de l'empilement peut être déposée par pulvérisation cathodique.

Sauf mention contraire, les épaisseurs évoquées dans le présent document sont des épaisseurs physiques. On entend par couche mince, une couche présentant une épaisseur comprise entre 0,1 nm et 100 micromètres.

Dans toute la description le substrat selon l'invention est considéré posé horizontalement. L'empilement de couches minces est déposé au-dessus du substrat. Le sens des expressions « au-dessus » et « en-dessous » et « inférieur » et « supérieur» est à considérer par rapport à cette orientation. A défaut de stipulation spécifique, les expressions « au-dessus » et « en-dessous » ne signifient pas nécessairement que deux couches et/ou revêtements sont disposés au contact l'un de l'autre. Lorsqu'il est précisé qu'une couche est déposée « au contact » d'une autre couche ou d'un revêtement, cela signifie qu'il ne peut y avoir une ou plusieurs couches intercalées entre ces deux couches.

La couche métallique fonctionnelle à base d'argent comprend au moins 95,0 %, de préférence au moins 96,5 % et mieux au moins 98,0 % en masse d'argent par rapport à la masse de la couche fonctionnelle. De préférence, la couche métallique fonctionnelle à base d'argent comprend moins de 1,0 % en masse de métaux autres que de l'argent par rapport à la masse de la couche métallique fonctionnelle à base d'argent.

L'épaisseur des couches fonctionnelles à base d'argent est par ordre de préférence croissant comprise de 5 à 20 nm, de 8 à 15 nm.

Les couches métalliques fonctionnelles à base d'argent peuvent être au contact d'une couche de blocage. Une sous-couche de blocage correspond à une couche de blocage disposée sous une couche fonctionnelle, position définie par rapport au substrat. Une couche de blocage disposée sur la couche fonctionnelle à l'opposé du substrat est appelée surcouche de blocage. Les surcouches de blocages sont choisies parmi les couches à base de NiCr, NiCrN, NiCrOx, NiO ou NbN. L'épaisseur de chaque surcouche ou sous-couche de blocage est de préférence :
- d'au moins 0,5 nm ou d'au moins 0,8 nm et/ou
- d'au plus 5,0 nm ou d'au plus 2,0 nm.

Selon l'invention, les couches à base d'oxyde de nickel cristallisé peuvent assurer la fonction de sous-couche de blocage. L'épaisseur de chaque couche à base d'oxyde de nickel cristallisé est de préférence :
- d'au moins 0,5 nm, d'au moins 0,8 nm, et/ou comprise entre 0,8 et 5 nm,
- d'au plus 5,0 nm, d'au plus 3,0 nm ou d'au plus 2,0 nm.

Les couches diélectriques des revêtements antireflets présentent les caractéristiques suivantes seules ou en combinaison :
- elles sont déposées par pulvérisation cathodique assistée par champ magnétique,
- elles sont choisies parmi les couches diélectriques à fonction barrière et/ou les couches diélectriques à fonction stabilisante,
- elles sont choisies parmi les oxydes ou nitrures d'un ou plusieurs éléments choisi(s) parmi le titane, le silicium, l'aluminium, l'étain et le zinc,
- elles ont une épaisseur supérieure à 5 nm, de préférence comprise entre 8 et 35 nm.

On entend par couches diélectriques à fonction stabilisante, une couche en un matériau apte à stabiliser l'interface entre la couche fonctionnelle et cette couche. Les couches diélectriques à fonction stabilisante sont de préférence à base d'oxyde cristallisé, notamment à base d'oxyde de zinc, éventuellement dopé à l'aide d'au moins un autre élément, comme l'aluminium. La ou les couches diélectriques à fonction stabilisante sont de préférence des couches d'oxyde de zinc.

La ou les couches diélectriques à fonction stabilisante peuvent se trouver au-dessus et/ou en-dessous d'au moins une couche métallique fonctionnelle à base d'argent ou de chaque couche métallique fonctionnelle à base d'argent, soit directement à son contact ou soit séparées par une couche d'oxyde de nickel ou par une couche de blocage. De préférence, chaque couche métallique fonctionnelle à base d'argent est au-dessus d'un revêtement antireflet dont la couche supérieure est une couche d'oxyde de nickel selon l'invention déposée au-dessus et au contact d'une couche diélectrique à fonction stabilisante, de préférence à base d'oxyde de zinc.

Les couches diélectriques à fonction stabilisante peuvent avoir une épaisseur d'au moins 3 nm, notamment une épaisseur comprise entre 3 et 25 nm et mieux de 5 à 10 nm.

On entend par couches diélectriques à fonction barrière, une couche en un matériau apte à faire barrière à la diffusion de l'oxygène et de l'eau à haute température, provenant de l'atmosphère ambiante ou du substrat transparent, vers la couche fonctionnelle. Les couches diélectriques à fonction barrière peuvent être à base de composés de silicium choisis parmi les oxydes tels que SiO₂, les nitrures de silicium Si₃N₄ et les oxynitures SiOₓN_{y}, éventuellement dopé à l'aide d'au moins un autre élément, comme l'aluminium, à base de nitrures d'aluminium AlN ou à base d'oxyde de zinc et d'étain.

Le substrat transparent revêtu de l'empilement destiné à subir un traitement thermique peut comprendre :
- un revêtement antireflet comprenant au moins une couche à base d'oxyde de nickel cristallisé,
- une couche métallique fonctionnelle à base d'argent,
- éventuellement une couche de blocage,
- un revêtement antireflet.

Selon un mode de réalisation avantageux, l'empilement peut comprendre en partant du substrat:
- un revêtement antireflet situé en-dessous de la couche métallique fonctionnelle à base d'argent comprenant au moins une couche diélectrique à fonction stabilisante à base d'oxyde de zinc et au moins une couche à base d'oxyde de nickel cristallisé située au contact de la couche diélectrique à fonction stabilisante à base d'oxyde de zinc,
- une couche métallique fonctionnelle à base d'argent située au contact de la couche à base d'oxyde de nickel cristallisé,
- éventuellement une surcouche de blocage,
- un revêtement antireflet situé au-dessus de la couche métallique fonctionnelle à base d'argent,
- éventuellement une couche de protection supérieure.

Selon un autre mode de réalisation avantageux, l'empilement peut comprendre en partant du substrat :
- un revêtement antireflet comprenant au moins une couche diélectrique à fonction barrière, au moins une couche diélectrique à fonction stabilisante et au moins une couche à base d'oxyde de nickel cristallisé,
- une couche métallique fonctionnelle à base d'argent située au contact de la couche à base d'oxyde de nickel cristallisé,
- éventuellement une surcouche de blocage,
- un revêtement antireflet comprenant au moins une couche diélectrique à fonction stabilisante et une couche diélectrique à fonction barrière.

L'empilement peut comprendre une couche supérieure de protection déposée comme dernière couche de l'empilement notamment pour conférer des propriétés anti-rayures. Ces couches supérieures de protection ont de préférence une épaisseur comprise entre 2 et 5 nm. Ces couches de protection peuvent être des couches d'oxyde de titane ou de 'oxyde de zinc et d'étain.

Les substrats transparents selon l'invention sont de préférence en un matériau rigide minéral, comme en verre, notamment silico-sodo-calcique. L'épaisseur du substrat varie généralement entre 0,5 mm et 19 mm. L'épaisseur du substrat est de préférence inférieure ou égale à 6 mm, voire 4 mm.

Le traitement thermique de cristallisation de la couche à base d'oxyde de nickel avant dépôt de la couche métallique fonctionnelle à base d'argent peut être réalisé par tout procédé de chauffage. Ce traitement peut être réalisé en plaçant le substrat dans un four ou une étuve ou en soumettant le substrat à un rayonnement.

Le traitement thermique de cristallisation est avantageusement réalisé en soumettant le substrat revêtu de la couche à traiter à un rayonnement, de préférence un rayonnement laser focalisé sur ladite couche sous la forme d'au moins une ligne laser.

Le traitement thermique de cristallisation peut être réalisé en apportant une énergie susceptible de porter chaque point de la couche à base d'oxyde de nickel à une température de préférence d'au moins 300°C, notamment 350°C, voire 400°C, et même 500°C ou 600°C. Chaque point du revêtement subit le traitement thermique pendant une durée inférieure ou égale à 1 seconde, voire 0,5 seconde et avantageusement comprise dans un domaine allant de 0,05 à 10 ms, notamment de 0,1 à 5 ms, ou de 0,1 à 2 ms.

La longueur d'onde du rayonnement est de préférence comprise dans un domaine allant de 500 à 2000 nm, notamment de 700 à 1100 nm, voire de 800 à 1000 nm. Des diodes laser de puissance émettant à une ou plusieurs longueurs d'onde choisie parmi 808 nm, 880 nm, 915 nm, 940 nm ou 980 nm se sont révélées particulièrement bien appropriées.

Le traitement thermique de cristallisation peut également être réalisé en soumettant le substrat à un rayonnement infrarouge issu de dispositifs de chauffage conventionnels tels que des lampes infrarouge.

Le traitement thermique est avantageusement réalisé de manière à ce que chaque point de la couche soit porté à une température d'au moins 300 °C tout en maintenant en tout point la face du substrat opposée à celle comprenant l'empilement à une température inférieure ou égale à 150 °C.

Par « point de la couche », on entend une zone de la couche subissant le traitement à un instant donné. Selon l'invention, la totalité de la couche (donc chaque point) est portée à une température d'au moins 300°C, mais chaque point de la couche n'est pas nécessairement traité simultanément. La couche peut être traitée au même instant dans son ensemble, chaque point de la couche étant simultanément porté à une température d'au moins 300°C. La couche peut alternativement être traitée de manière à ce que les différents points de la couche ou des ensembles de points soient successivement portés à une température d'au moins 300°C, ce deuxième mode étant plus souvent employé dans le cas d'une mise en oeuvre continue à l'échelle industrielle.

Ces traitements thermiques présentent l'avantage de ne chauffer que la couche, sans échauffement significatif de la totalité du substrat, chauffage modéré et contrôlé d'une zone limitée du substrat, et donc d'éviter des problèmes de casse. Il est donc préférable pour la mise en oeuvre de la présente invention que la température de la face du substrat opposée à la face portant la couche présentant un saut de contrainte traitée ne soit pas supérieure à 150°C de préférence inférieure ou égale à 100 °C, notamment à 50 °C. Cette caractéristique est obtenue en choisissant un mode de chauffage spécialement adapté au chauffage de la couche et non du substrat et en contrôlant le temps ou l'intensité de chauffage et/ou d'autres paramètres en fonction du mode de chauffage employé. De préférence, chaque point de la couche mince est soumis au traitement selon l'invention (c'est-à-dire porté à une température supérieure ou égale à 300°C) pour une durée généralement inférieure ou égale à 1 seconde, voire 0,5 seconde.

Afin de limiter au maximum le nombre de casses pour les substrats les plus grands (par exemple de 6 m de long sur 3 m de large), on maintient de préférence tout au long du traitement une température inférieure ou égale à 100°C, notamment 50°C, en tout point de la face du substrat opposée à la face sur laquelle est déposée la couche présentant un saut de contrainte.

Les paramètres du chauffage tels que la puissance des moyens de chauffage ou le temps de chauffage sont à adapter au cas par cas par l'homme du métier en fonction de divers paramètres tels que la nature du procédé de chauffage, l'épaisseur de la couche, la taille et l'épaisseur des substrats à traiter etc.

L'étape de traitement thermique de cristallisation consiste de préférence à soumettre le substrat revêtu de la couche à traiter à un rayonnement, de préférence un rayonnement laser focalisé sur ladite couche sous la forme d'au moins une ligne laser. Les lasers ne pouvant irradier qu'une faible surface (typiquement de l'ordre d'une fraction de mm² à quelque centaines de mm²), il est nécessaire, afin de traiter toute la surface, de prévoir un système de déplacement du faisceau laser dans le plan du substrat ou un système formant un faisceau laser en ligne irradiant simultanément toute la largeur du substrat, et sous laquelle ce dernier vient défiler.

La température maximale est normalement subie au moment où le point du revêtement considéré passe sous la ligne laser. A un instant donné, seuls les points de la surface du revêtement situés sous la ligne laser et dans ses environs immédiats (par exemple à moins d'un millimètre) sont normalement à une température d'au moins 300°C. Pour des distances à la ligne laser (mesurées selon la direction de défilement) supérieures à 2 mm, notamment 5 mm, y compris en aval de la ligne laser, la température du revêtement est normalement d'au plus 50°C, et même 40°C ou 30°C.

Le rayonnement laser est de préférence généré par des modules comprenant une ou plusieurs sources laser ainsi que des optiques de mise en forme et de redirection.

Les sources laser sont typiquement des diodes laser ou des lasers à fibre ou à disque. Les diodes laser permettent d'atteindre de manière économique de fortes densités de puissance par rapport à la puissance électrique d'alimentation, pour un faible encombrement.

Le rayonnement issu des sources laser est de préférence continu.

Les optiques de mise en forme et de redirection comprennent de préférence des lentilles et des miroirs, et sont utilisées comme moyens de positionnement, d'homogénéisation et de focalisation du rayonnement.

Les moyens de positionnement ont pour but le cas échéant de disposer selon une ligne les rayonnements émis par les sources laser. Ils comprennent de préférence des miroirs. Les moyens d'homogénéisation ont pour but de superposer les profils spatiaux des sources laser afin d'obtenir une puissance linéique homogène tout au long de la ligne. Les moyens d'homogénéisation comprennent de préférence des lentilles permettant la séparation des faisceaux incidents en faisceaux secondaires et la recombinaison desdits faisceaux secondaires en une ligne homogène. Les moyens de focalisation du rayonnement permettent de focaliser le rayonnement sur le revêtement à traiter, sous la forme d'une ligne de longueur et de largeur voulues. Les moyens de focalisation comprennent de préférence une lentille convergente.

Lorsqu'une seule ligne laser est utilisée, la longueur de la ligne est avantageusement égale à la largeur du substrat.

La puissance linéique de la ligne laser est de préférence d'au moins 300 W/cm, avantageusement 350 ou 400 W/cm, notamment 450 W/cm, voire 500 W/cm et même 550 W/cm. Elle est même avantageusement d'au moins 600 W/cm, notamment 800 W/cm, voire 1000 W/cm. La puissance linéique est mesurée à l'endroit où la ou chaque ligne laser est focalisée sur le revêtement. Elle peut être mesurée en disposant un détecteur de puissance le long de la ligne, par exemple un puissance-mètre calorimétrique, tel que notamment le puissance-mètre Beam Finder S/N 2000716 de la société Coherent Inc. La puissance est avantageusement répartie de manière homogène sur toute la longueur de la ou chaque ligne. De préférence, la différence entre la puissance la plus élevée et la puissance la plus faible vaut moins de 10% de la puissance moyenne.

La densité d'énergie fournie au revêtement est de préférence d'au moins 20 J/cm², voire 30 J/cm².

Les puissances et densités d'énergies élevées permettent de chauffer le revêtement très rapidement, sans échauffer le substrat de manière significative.

De préférence, la ou chaque ligne laser est fixe, et le substrat est en mouvement, si bien que les vitesses de déplacement relatif correspondront à la vitesse de défilement du substrat.

Le traitement thermique de cristallisation peut être réalisé pendant le dépôt dans l'enceinte de dépôt, soit à l'issue du dépôt, en dehors de l'enceinte de dépôt. Le traitement thermique de cristallisation peut se faire sous vide, sous air et/ou à pression atmosphérique. Le traitement thermique en dehors de l'enceinte de dépôt n'est pas préféré car il peut générer des problèmes de pollution

Le traitement thermique de cristallisation peut être réalisé sous vide au sein même de l'enceinte de dépôt par pulvérisation cathodique. De préférence, toutes les couches de l'empilement et le traitement thermique de cristallisation sont réalisés dans l'enceinte de dépôt par pulvérisation cathodique

Le dispositif de traitement thermique peut donc être intégré dans une ligne de dépôt de couches, par exemple une ligne de dépôt par pulvérisation cathodique assistée par champ magnétique (procédé magnétron). La ligne comprend en général des dispositifs de manutention des substrats, une installation de dépôt, des dispositifs de contrôle optique, des dispositifs d'empilage. Les substrats défilent, par exemple sur des rouleaux convoyeurs, successivement devant chaque dispositif ou chaque installation.

Le dispositif de traitement thermique peut être intégré à l'installation de dépôt. Par exemple, le laser peut être introduit dans une des chambres d'une installation de dépôt par pulvérisation cathodique, notamment dans une chambre où l'atmosphère est raréfiée, notamment sous une pression comprise entre 10⁻⁶ mbar et 10⁻² mbar. Le dispositif de traitement thermique peut aussi être disposé en dehors de l'installation de dépôt, mais de manière à traiter un substrat situé à l'intérieur de ladite installation. Il suffit de prévoir à cet effet un hublot transparent à la longueur d'onde du rayonnement utilisé, au travers duquel le rayonnement laser viendrait traiter la couche. Il est ainsi possible de traiter une couche avant le dépôt subséquent d'une autre couche dans la même installation. Le traitement thermique est de préférence un traitement laser par rayonnement dans un système où le laser est intégré dans un dispositif magnétron.

De préférence, le traitement thermique est réalisé sous vide au sein même de l'enceinte de dépôt du dispositif magnétron.

Le traitement thermique de cristallisation peut également être réalisé par chauffage à l'aide d'un rayonnement infrarouge, d'une torche plasma ou d'une flamme tel que décrit dans la demande WO 2008/096089.

Des systèmes de lampes infrarouges associées à un dispositif de focalisation (par exemple une lentille cylindrique) permettant d'atteindre de fortes puissances par unité de surface sont également utilisables.

Le traitement thermique de cristallisation est de préférence un traitement laser intégré dans une un enceinte de dépôt par pulvérisation cathodique.

Les substrats transparents selon l'invention sont de préférence en un matériau rigide minéral, comme en verre, notamment silico-sodo-calcique. L'épaisseur du substrat varie généralement entre 0,5 mm et 19 mm. L'épaisseur du substrat est de préférence inférieure ou égale à 6 mm, voire 4 mm.

Le substrat transparent revêtu peut subir un traitement thermique à température élevée choisi parmi un recuit, par exemple par un recuit flash tel qu'un recuit laser ou flammage, une trempe et/ou un bombage. La température du traitement thermique est supérieure à 400 °C, de préférence supérieure à 450 °C, et mieux supérieure à 500 °C. Ce traitement thermique réalisé sur l'empilement complet se distingue du traitement thermique de cristallisation. Le procédé peut comprendre en outre l'étape (c) pendant laquelle on soumet le substrat revêtu de l'empilement de couches minces à un traitement thermique à une température supérieure à 400 °C, de préférence 500 °C.

Le substrat revêtu de l'empilement peut être est un verre bombé et/ou trempé.

Le matériau peut être sous forme de vitrage monolithique, de vitrage feuilleté ou d'un vitrage multiple notamment un double-vitrage ou un triple vitrage.

Le matériau de l'invention convient dans toutes applications nécessitant l'utilisation d'un empilement bas-émissif comprenant des couches d'argent pour lesquelles une faible résistivité est un paramètre clé.

### Exemples

Des empilements de couches minces définis ci-après sont déposés sur des substrats en verre sodo-calcique clair d'une épaisseur de 2 mm.

Pour ces exemples, les conditions de dépôt des couches déposées par pulvérisation (pulvérisation dite « cathodique magnétron ») sont résumées dans le tableau 1 ci-dessous.

Les couches d'oxyde de titane déposées en tant que couche diélectrique du revêtement antireflet ou en tant que couche de blocage peuvent être totalement ou partiellement oxydées. Pour cela on utilise une cible céramique de TiOx sous-stoechiométrique et on procède au dépôt soit en atmosphère oxydante pour obtenir une couche de TiO₂ totalement oxydée, soit en atmosphère inerte pour obtenir une couche sous-stoechiométrique.

Pour certains exemples, on fait varier les épaisseurs de couches en modifiant la puissance de dépôt.

| Tableau 1 | Cibles employées | Pression dépôt | Gaz | Indice* |
|---|---|---|---|---|
| Si₃N₄ | Si:Al (92:8 % en pds) | 1,5*10⁻³ mbar | Ar 47 % - N₂ 53 % | 2,00 |
| ZnO | Zn:AI (98:2 % en pds) | 1,5*10⁻³ mbar | Ar 91 % - O₂ 9 % | 2,04 |
| NiCr | Ni : Cr (80 : 20% at.) | 2*10⁻³ mbar | Ar à 100 % | - |
| Ag | Ag | 8*10⁻³ mbar | Ar à 100 % | - |
| TiO₂ | TiOx | 1,5*10⁻³ mbar | Ar 88 % - O₂ 12% | 2,32 |
| SnZnO | Sn:Zn (60:40% en pds) | 1,5*10⁻³ mbar | Ar 39 % - O₂ 61 % | 2,09 |
| NiO | Ni | 2,5*10⁻³ mbar | Ar 97% - O₂ 3% | - |

| | | | | |
|---|---|---|---|---|
| at. : atomique ; pds : poids ; * : à 550 nm. | | | | |

Les tableaux ci-dessous listent les matériaux et les épaisseurs physiques en nanomètres (sauf autres indications) de chaque couche ou revêtement qui constitue les empilements en fonction de leurs positions vis-à-vis du substrat porteur de l'empilement.

| **Vitrage** | | **Comparatif** | | | **Selon l'invention** | | | | |
|---|---|---|---|---|---|---|---|---|---|
| | | C1a | C1b | A1a | A1b | A2a | A2b | A3a | A3b |
| Revêtement antireflet | Si3N4 | 10 | 10 | 10 | 10 | 10 | 10 | 10 | 10 |
| | ZnO | 5 | 5 | 5 | 5 | 5 | 5 | 5 | 5 |
| Couche blocage OB | NiCr | 0,5 | 0,5 | 0,5 | 0,5 | 0,5 | 0,5 | 0,5 | 0,5 |
| Couche fonctionnelle | Ag | 10 | 10 | 10 | 10 | 10 | 10 | 10 | 10 |
| Revêtement antireflet | NiO | - | - | 10 | 10 | 1 | 1 | 5 | 5 |
| | ZnO | 10 | 10 | - | - | 10 | 10 | 5 | 5 |
| | Si₃N₄ | 30 | 30 | 30 | 30 | 30 | 30 | 30 | 30 |
| Substrat (mm) | verre | 2 | 2 | 2 | 2 | 2 | 2 | 2 | 2 |
| Traitement thermique de cristallisation | - | non | oui | non | oui | non | oui | non | oui |

| **Vitrage** | | **Comparatif** | | | | | **Selon l'invention** | | |
|---|---|---|---|---|---|---|---|---|---|
| | | C2a | C2b | C3a | C3b | C5 | A4a | A4b | A6 |
| Couche supérieure protection | TiO₂ | 2 | 2 | 2 | 2 | 2 | 2 | 2 | 2 |
| Revêtement antireflet | Si₃N₄ | 30 | 30 | 30 | 30 | 30 | 30 | 30 | 30 |
| | ZnO | 5 | 5 | 5 | 5 | 5 | 5 | 5 | 5 |
| Couche blocage OB | NiCr | 0,5 | 0,5 | 0,5 | 0,5 | 0,5 | 0,5 | 0,5 | 0,5 |
| Couche fonctionnelle | Ag | 10 | 10 | 10 | 10 | 10 | 10 | 10 | 10 |
| Revêtement antireflet | NiO | - | - | 10 | 10 | - | 1 | 1 | 1 |
| | ZnO | 10 | 10 | - | - | 10 | 10 | 10 | 10 |
| | Si₃N₄ | 30 | 30 | 30 | 30 | 30 | 30 | 30 | 30 |
| Substrat (mm) | verre | 2 | 2 | 2 | 2 | 4 | 2 | 2 | 4 |
| Traitement thermique de cristallisation | - | non | non | non | non | non | non | non | non |
| Traitement thermique Empilement complet | - | non | oui | non | oui | non | non | oui | non |

Un traitement de thermique de cristallisation peut être réalisé avant dépôt de la couche fonctionnelle à base d'argent par traitement laser. Pour les exemples décrits ci-dessus, le traitement thermique de l'empilement complet est réalisé également par traitement laser.

| **Vitrages** | | Comparatif | | | | | | | Selon l'invention | | |
|---|---|---|---|---|---|---|---|---|---|---|---|
| | | **1** | **2** | **3** | **4** | **5** | **6** | **7** | **8** | **9** | **10** |
| Couche protectrice | TiO₂ | 2 | 2 | 2 | 2 | 2 | 2 | 2 | 2 | 2 | 2 |
| Revêtement antireflet | Si₃N₄ | 30 | 30 | 30 | 30 | 30 | 30 | 30 | 30 | 30 | 30 |
| | ZnO | 5 | 5 | 5 | 5 | 5 | 5 | 5 | 5 | 5 | 5 |
| Couche blocage | NiCr | 0,5 | 0,5 | 0,5 | 0,5 | 0,5 | 0,5 | 0,5 | 0,5 | 0,5 | 0,5 |
| Couche fonctionnelle | Ag | 10 | 10 | 10 | 10 | 10 | 10 | 10 | 10 | 10 | 10 |
| Couche blocage | NiCr | - | 0,5 | 1 | 3 | - | - | - | - | - | - |
| | TiOₓ | - | - | - | - | 0,5 | 1 | 3 | - | - | - |
| Couche de croissance | NiO | - | - | - | - | - | - | - | 0,5 | 1 | 3 |
| Revêtement antireflet | ZnO | 5 | 5 | 5 | 5 | 5 | 5 | 5 | 5 | 5 | 5 |
| | SnZnOₓ | 30 | 30 | 30 | 30 | 30 | 30 | 30 | 30 | 30 | 30 |
| Substrat (mm) | verre | 2 | 2 | 2 | 2 | 2 | 2 | 2 | 2 | 2 | 2 |
| Traitement thermique Empilement complet | | oui | oui | oui | oui | oui | oui | oui | oui | oui | oui |

Pour les exemples décrits ci-dessus, le traitement thermique de l'empilement complet est réalisé dans un four Naber simulant une trempe avec un recuit à 620 °C ou 680 °C pendant 10 minutes.

### I. Evaluation de la résistance par carré

La résistance par carré (Rsq), correspondant à la résistance d'un échantillon de largeur égale à la longueur (par exemple 1 mètre) et d'épaisseur quelconque, est mesurée au Napson. La première série d'essai compare l'effet de la nature de la couche de croissance et de son mode de cristallisation. Le tableau ci-dessous reprend les résultats de résistance par carré obtenus pour des substrats revêtus ayant ou non subi un traitement thermique de cristallisation.

| **Vitrage** | C1a | C1b | A1a | A1b | A2a | A2b | A3a | A3b |
|---|---|---|---|---|---|---|---|---|
| Rsq (± 0,05 ohm) | 5,53 | 5,55 | 5,80 | 5,66 | 5,28 | 5,15 | 5,55 | 5,27 |

Un traitement thermique de cristallisation réalisé avant dépôt de la couche d'argent sur le matériau de l'art antérieur ne comprenant pas une couche de croissance à base d'oxyde de nickel n'a pas d'effet positif sur la résistance par carré.

L'exemple A1a illustre un matériau comprenant une couche d'oxyde de nickel peu ou pas cristallisé avant dépôt de la couche d'argent. En effet, cette couche n'est pas déposée sur une couche susceptible d'induire une cristallisation par épitaxie et aucun traitement de cristallisation n'est réalisé. La résistance par carré de ce matériau est donc élevée. Par comparaison, l'exemple A1b selon l'invention diffère en ce qu'en traitement thermique de cristallisation a été réalisé avant dépôt de la couche d'argent. La résistance par carré de ce matériau est inférieure à celle de l'exemple A1a. La couche d'oxyde de nickel cristallisé peut permettre l'abaissement des valeurs de résistance par carré.

Les exemples A2a et A3a illustrent des matériaux selon l'invention comprenant une couche d'oxyde de nickel cristallisée avant dépôt de la couche d'argent. En effet, la couche d'oxyde de nickel est déposée sur une couche d'oxyde de zinc susceptible d'induire une cristallisation par épitaxie. Les deux matériaux ainsi préparés sans traitement thermique de cristallisation ont une résistance par carré faible et notamment au moins aussi bonne que celle du matériau C1a comprenant uniquement une couche à base d'oxyde de zinc. Il est intéressant de noter que sans traitement thermique de cristallisation additionnel, les meilleurs résultats sont obtenus pour le matériau A2a comprenant la séquence couche à base d'oxyde de zinc et couche à base d'oxyde de nickel de faible épaisseur.

Enfin, les exemples A2b et A3b illustrent des matériaux selon l'invention comprenant une couche d'oxyde de nickel cristallisée avant dépôt de la couche d'argent. La cristallisation est obtenue à la fois par épitaxie car la couche d'oxyde de nickel est déposée sur une couche d'oxyde de zinc susceptible d'induire une cristallisation et par traitement thermique de cristallisation additionnel à l'aide d'un laser. Les deux matériaux ainsi préparés ont une résistance par carré faible et notamment plus faible que celle des matériaux A2a et A3a ne comprenant pas le traitement thermique de cristallisation additionnel. Cela traduit de l'effet synergique de la cristallisation à la fois par épitaxie et par traitement thermique sur l'obtention de faible valeur de résistance par carré. Enfin, les meilleurs résultats sont obtenus pour le matériau A2b comprenant la séquence d'une couche à base d'oxyde de zinc et d'une couche à base d'oxyde de nickel de faible épaisseur.

La seconde série d'essai met en évidence l'importance de la cristallisation de la couche à base d'oxyde de nickel avant dépôt de la couche d'argent. Le tableau ci-dessous reprend les résultats de résistance par carré obtenus pour des substrats revêtus :
- n'ayant pas subi de traitement thermique de cristallisation,
- ayant ou non subi un traitement thermique réalisé sur l'empilement complet. Pour cela, le traitement thermique laser est réalisé sur l'empilement complet.

| **Vitrage** | C2a | C2b | C3a | C3b | A4a | A4b |
|---|---|---|---|---|---|---|
| Rsq (± 0,05 ohm) | 4,89 | 3,97 | 6,02 | 4,80 | 5,21 | 4,22 |

Un traitement thermique réalisé sur l'empilement complet conduit dans tous les cas à une diminution des valeurs de résistance par carré. Cependant, on observe que les valeurs de résistance par carré les plus basses sont obtenues pour le matériau de l'art antérieur ne comprenant pas une couche de croissance à base d'oxyde de nickel mais uniquement une couche d'oxyde de zinc. La couche fonctionnelle à base d'argent doit impérativement être déposée sur une couche de croissance à base d'oxyde de nickel cristallisé pour obtenir un effet positif lié à la présence de cette couche. Un traitement thermique après dépôt de la couche d'argent ne permet pas d'obtenir d'amélioration en termes de résistances carré par rapport à un empilement de l'art antérieur comprenant uniquement une couche d'oxyde de zinc.

### II. Evaluation de la résistance mécanique : test de pelage

La résistance mécanique a été évaluée par à un test de pelage qui renseigne sur la cohésion des couches constituant l'empilement. Ce test de pelage consiste à faire adhérer une feuille de PVB sous l'application de chaleur et de pression au substrat revêtu de l'empilement. La couche de PVB placée au contact avec l'empilement est alors séparée à une extrémité et est repliée et tirée du substrat revêtu sous un angle d'application de force de 180 degrés. La force nécessaire pour arracher la feuille de PVB est une mesure de l'adhérence de la feuille de PVB à l'empilement et de la cohésion des couches.

| **Vitrage** | **C5** | **A6** |
|---|---|---|
| Force d'arrachement (N) | 3,2 | 12,5 |

Ces essais ont été réalisés sur des matériaux n'ayant pas subi de traitement thermique à température élevé. Ils mettent clairement en évidence la meilleure adhésion de l'ensemble de l'empilement lié à la présence de la couche d'oxyde de nickel cristallisé avant dépôt de la couche d'argent. Cette excellente adhésion de l'argent sur l'oxyde de nickel concourt à l'obtention d'une meilleure durabilité au traitement thermique de l'empilement comprenant une couche à base d'oxyde de nickel cristallisé au-dessous et au-contact d'une couche d'argent.

### III. Propriétés optiques

Les caractéristiques optiques ont été mesurées pour des vitrages simples comprenant un verre de 2 mm sur lequel est déposé l'empilement.

Ces essais montrent l'influence de la nature et de l'épaisseur des sous couches de blocage sur les propriétés optiques avant et après traitement thermique.

Les caractéristiques suivantes ont été mesurées et regroupées dans le tableau ci-dessous :
- les valeurs d'émissivité en pourcentage (ε) calculées selon la norme EN 12898 avant et après traitement thermique,
- les valeurs d'absorption (Abs) avant traitement thermique et
- le flou évalué en mesurant après traitement thermique.

Le flou a été évalué par mesure de la réflexion diffuse visible moyenne au spectromètre Perkin-Elmer L900. La mesure consiste à faire la moyenne de la partie diffusée de la réflexion sur le domaine du visible, en excluant la réflexion spéculaire de la mesure et en soustrayant la ligne de base prise sur un échantillon de référence non flou. Il s'exprime en pourcentage par rapport à une réflexion totale mesurée sur un miroir de référence.

| **Vitrage** | **Avant Traitement thermique** | | **Après traitement thermique** | |
|---|---|---|---|---|
| | **ε %** | **Abs %** | **ε %** | **Flou %** |
| 1 | 4,49 | 6,6 | 11,44 | 1,22 |
| 2 | 6,05 | 11,9 | 4,81 | 0,34 |
| 3 | 5,83 | 14,8 | 4,75 | 0,13 |
| 4 | 5,40 | 26,4 | 4,87 | 0,29 |
| 5 | 5,62 | 8,1 | 4,11 | 0,23 |
| 6 | 5,64 | 8,0 | 5,20 | 0,37 |
| 7 | 5,55 | 8,0 | 4,54 | 0,30 |
| 8 | 4,93 | 7,9 | 4,37 | 1,45 |
| 9 | 4,86 | 7,8 | 4,68 | 0,34 |
| 10 | 4,78 | 8,0 | 4,36 | 0,58 |

Les vitrages 1 à 10 comprennent une couche diélectrique à base d'oxyde d'étain et de zinc (SnZnO) dans le revêtement antireflet situé en-dessous de la couche fonctionnelle métallique à base d'argent. Le demandeur a découvert que la présence d'une couche de cette nature et dans cette position de l'empilement favorise la formation de défaut de type dôme après traitement thermique. Le choix de la couche de blocage située en-dessous de la couche fonctionnelle accentue ou diminue cette tendance.

L'ajout d'une sous-couche de blocage provoque une augmentation de l'absorption dans le visible avant trempe. Cependant, l'augmentation est moins forte dans le cas de l'utilisation d'une sous couche de blocage à base d'oxyde. Les couches de blocage à base de nickel et de chrome augmentent beaucoup l'absorption dans le visible.

L'ajout d'une couche selon l'invention à base d'oxyde de nickel cristallisé et de faible épaisseur ne produit pas de variation significative des valeurs d'émissivité avant et après traitement thermique contrairement à l'ajout d'une sous-couche à base de nickel et de chrome.

Après traitement thermique, les vitrages selon l'invention présentent une émissivité plus faible que celle obtenue avec une sous-couche de blocage à base de nickel et de chrome. L'obtention d'une faible émissivité rend compte d'une réduction des pertes d'énergie par rayonnement et donc d'une amélioration de la performance thermique du double vitrage.

En effet, les vitrages comprenant une sous-couche de blocage à base d'un alliage de nickel et de chrome présentent des valeurs de flou correctes mais ne présentent pas les propriétés avantageuses de l'invention en termes d'émissivité et d'absorption.

L'utilisation d'une couche de blocage à base d'oxyde de nickel cristallisé présentant une épaisseur de l'ordre d'1 nm permet une diminution du flou significative par rapport à un matériau sans sous-couche de blocage. Elle permet également une diminution du flou au moins équivalente à celle obtenue avec une sous-couche de blocage à base de nickel et de chrome de 0,5 nm classiquement utilisée. Mais surtout, la couche de croissance selon l'invention permet d'obtenir les absorptions ainsi que les valeurs d'émissivités les plus basses, même avant traitement thermique, par rapport aux autres sous-couches de blocage.

## Revendications

1. Procédé d'obtention d'un matériau comprenant un substrat transparent revêtu d'un empilement de couches minces déposées par pulvérisation cathodique éventuellement assistée par champ magnétique, comprenant au moins une couche métallique fonctionnelle à base d'argent et au moins deux revêtements antireflets, chaque revêtement antireflet comportant au moins une couche diélectrique, de manière à ce que chaque couche métallique fonctionnelle soit disposée entre deux revêtements antireflets, le procédé comporte la séquence d'étapes suivantes :
(a)on dépose un revêtement antireflet comportant au moins une couche mince à base d'oxyde de nickel cristallisé, puis
(b)on dépose au moins une couche métallique fonctionnelle à base d'argent au-dessus et au contact de la couche mince à base d'oxyde de nickel cristallisé.

2. Procédé d'obtention d'un matériau selon la revendication 1 tel que pendant l'étape (a) :
- on dépose une couche susceptible d'induire une cristallisation par épitaxie puis
- on dépose au-dessus et au contact une couche à base d'oxyde de nickel.

3. Procédé d'obtention d'un matériau selon la revendication 1 ou 2 tel que pendant l'étape (a) :
- on dépose une couche à base d'oxyde de zinc cristallisé puis
- on dépose au-dessus et au contact une couche à base d'oxyde de nickel.

4. Procédé d'obtention d'un matériau selon l'une quelconque des revendications précédentes tel que pendant l'étape (a) :
- on dépose une couche à base d'oxyde de nickel cristallisé ou non cristallisé puis
- on soumet la couche mince à base d'oxyde de nickel cristallisé ou non cristallisé à un traitement thermique de cristallisation avant dépôt de la couche métallique fonctionnelle à base d'argent.

5. Procédé d'obtention d'un matériau selon la revendication 4, tel que le traitement thermique de cristallisation est réalisé en apportant une énergie susceptible de porter chaque point de la couche mince à base d'oxyde de nickel cristallisé ou non cristallisé à une température supérieure ou égale à 300°C.

6. Procédé d'obtention d'un matériau selon l'une quelconque des revendications précédentes tel que toutes les couches de l'empilement et le traitement thermique de cristallisation sont réalisés dans l'enceinte de dépôt par pulvérisation cathodique.

7. Procédé d'obtention d'un matériau selon l'une quelconque des revendications précédentes tel qu'il comprend en outre l'étape (c) pendant laquelle on soumet le substrat revêtu de l'empilement de couches minces à un traitement thermique à une température supérieure à 400 °C, de préférence 500 °C.

8. Matériau comprenant un substrat transparent revêtu d'un empilement de couches minces comprenant au moins une couche métallique fonctionnelle à base d'argent, au moins deux revêtements antireflets, chaque revêtement antireflet comportant au moins une couche diélectrique, de manière à ce que chaque couche métallique fonctionnelle soit disposée entre deux revêtements antireflets **caractérisé en ce que** l'empilement comprend au moins une couche à base d'oxyde de nickel cristallisé située en-dessous et au-contact d'une couche métallique fonctionnelle à base d'argent comprenant plusieurs grains monocristallins orientés de sorte qu'ils aient la famille de plans {200} parallèles à la surface du substrat.

9. Matériau selon la revendication 8, **caractérisé en ce que** le revêtement antireflet situé en-dessous de la couche fonctionnelle à base d'argent comprenant plusieurs grains monocristallins orientés de sorte qu'ils aient la famille de plans {200} parallèles à la surface du substrat comprend une couche diélectrique susceptible de générer des défauts de type dôme choisie parmi les couches à base d'oxyde de zinc et d'étain.

10. Matériau selon l'une quelconque des revendications 8 à 9, **caractérisé en ce que** le revêtement antireflet situé en-dessous de la couche fonctionnelle à base d'argent comprenant plusieurs grains monocristallins orientés de sorte qu'ils aient la famille de plans {200} parallèles à la surface du substrat comprend une couche diélectrique à fonction stabilisante à base d'oxyde de zinc située au-dessous et au contact de la couche à base d'oxyde de nickel cristallisé.

11. Matériau selon l'une quelconque des revendications 8 à 10, **caractérisé en ce que** la couche à base d'oxyde de nickel cristallisé présente une épaisseur d'au moins 0,5 nm, de préférence comprise entre 0,8 et 5 nm.

12. Matériau selon l'une quelconque des revendications 8 à 11, **caractérisé en ce que** la couche à base d'oxyde de nickel cristallisé présente une épaisseur inférieure à 4 nm, de préférence inférieure à 3 nm, et mieux inférieure à 2 nm.

13. Matériau selon l'une quelconque des revendications 8 à 12, **caractérisé en ce que** l'empilement comprend :
- un revêtement antireflet situé en-dessous de la couche métallique fonctionnelle à base d'argent comprenant au moins une couche diélectrique à fonction stabilisante à base d'oxyde de zinc et au moins une couche à base d'oxyde de nickel cristallisé située au contact de la couche diélectrique à fonction stabilisante à base d'oxyde de zinc,
- une couche métallique fonctionnelle à base d'argent située au contact de la couche à base d'oxyde de nickel,
- éventuellement une surcouche de blocage,
- un revêtement antireflet situé au-dessus de la couche métallique fonctionnelle à base d'argent,
- éventuellement une couche de protection supérieure.

14. Matériau selon l'une quelconque des revendications 8 à 13 **caractérisé en ce qu'**au moins le substrat revêtu de l'empilement est un verre bombé et/ou trempé.

15. Matériau selon l'une quelconque des revendications 8 à 14 tel que le substrat est en verre, notamment silico-sodo-calcique.

## Patentansprüche

1. Verfahren zum Erhalten eines Materials, das ein transparentes Substrat umfasst, das mit einem Schichtsystem aus dünnen Schichten beschichtet ist, die, gegebenenfalls magnetfeldunterstützt, aufgesputtert werden, umfassend mindestens eine metallische Funktionsschicht auf Silberbasis und mindestens zwei Antireflexbeschichtungen, wobei jede Antireflexbeschichtung mindestens eine dielektrische Schicht umfasst, so dass jede metallische Funktionsschicht zwischen zwei Antireflexbeschichtungen angeordnet ist, wobei das Verfahren die Folge aus den folgenden Schritten umfasst:
(a) es wird eine Antireflexbeschichtung aufgebracht, die mindestens eine dünne Schicht auf der Basis von kristallisiertem Nickeloxid umfasst, und dann
(b) wird mindestens eine metallische Funktionsschicht auf Silberbasis über und in Kontakt mit der dünnen Schicht auf der Basis von kristallisiertem Nickeloxid aufgebracht.

2. Verfahren zum Erhalten eines Materials nach Anspruch 1, wobei während des Schritts (a):
- eine Schicht aufgebracht wird, die geeignet ist, eine Kristallisation durch Epitaxie zu induzieren, und dann
- darüber und in Kontakt eine Schicht auf Nickeloxidbasis aufgebracht wird.

3. Verfahren zum Erhalten eines Materials nach Anspruch 1 oder 2, wobei während des Schritts (a):
- eine Schicht auf der Basis von kristallisiertem Zinkoxid aufgebracht wird und dann
- darüber und in Kontakt eine Schicht auf Nickeloxidbasis aufgebracht wird.

4. Verfahren zum Erhalten eines Materials nach einem der vorhergehenden Ansprüche, wobei während des Schritts (a):
- eine Schicht auf der Basis von kristallisiertem oder nicht kristallisiertem Zinkoxid aufgebracht wird und dann
- die dünne Schicht auf der Basis von kristallisiertem oder nicht kristallisiertem Nickeloxid vor dem Aufbringen der metallischen Funktionsschicht auf Silberbasis einer thermischen Kristallisationsbehandlung unterzogen wird.

5. Verfahren zum Erhalten eines Materials nach Anspruch 4, wobei die thermische Kristallisationsbehandlung ausgeführt wird, indem eine Energie zugeführt wird, die geeignet ist, jeden Punkt der dünnen Schicht auf der Basis von kristallisiertem oder nicht kristallisiertem Nickeloxid auf eine Temperatur größer oder gleich 300 °C zu bringen.

6. Verfahren zum Erhalten eines Materials nach einem der vorhergehenden Ansprüche, wobei alle Schichten des Schichtsystems und die thermische Kristallisationsbehandlung in der Aufsputterkammer ausgeführt werden.

7. Verfahren zum Erhalten eines Materials nach einem der vorhergehenden Ansprüche, wobei es ferner den Schritt (c) umfasst, während dessen das Substrat, das mit dem Schichtsystem aus dünnen Schichten beschichtet ist, einer thermischen Behandlung bei einer Temperatur über 400 °C, bevorzugt 500 °C, unterzogen wird.

8. Material, das ein transparentes Substrat umfasst, das mit einem Schichtsystem aus dünnen Schichten beschichtet ist, das mindestens eine metallische Funktionsschicht auf Silberbasis, mindestens zwei Antireflexbeschichtungen umfasst, wobei jede Antireflexbeschichtung mindestens eine dielektrische Schicht umfasst, so dass jede metallische Funktionsschicht zwischen zwei Antireflexbeschichtungen angeordnet ist, **dadurch gekennzeichnet, dass** das Schichtsystem mindestens eine Schicht auf der Basis von kristallisiertem Nickeloxid umfasst, die unter und in Kontakt mit einer metallischen Funktionsschicht auf Silberbasis angeordnet ist, die mehrere monokristalline Körner umfasst, die so ausgerichtet sind, dass ihre Ebenenschar {200} parallel zur Oberfläche des Substrats verläuft.

9. Material nach Anspruch 8, **dadurch gekennzeichnet, dass** die Antireflexbeschichtung, die unter der Funktionsschicht auf Silberbasis gelegen ist, die mehrere monokristalline Körner umfasst, die so ausgerichtet sind, dass ihre Ebenenschar {200} parallel zur Oberfläche des Substrats verläuft, eine dielektrische Schicht umfasst, die geeignet ist, kuppelförmige Fehler zu erzeugen, die unter den Schichten auf Zink- und Zinnoxidbasis gewählt wird.

10. Material nach einem der Ansprüche 8 bis 9, **dadurch gekennzeichnet, dass** die Antireflexbeschichtung, die unter der Funktionsschicht auf Silberbasis gelegen ist, die mehrere monokristalline Körner umfasst, die so ausgerichtet sind, dass ihre Ebenenschar {200} parallel zur Oberfläche des Substrats verläuft, eine dielektrische Schicht mit stabilisierender Funktion auf Zinkoxidbasis umfasst, die unter und in Kontakt mit der Schicht auf der Basis von kristallisiertem Nickeloxid gelegen ist.

11. Material nach einem der Ansprüche 8 bis 10, **dadurch gekennzeichnet, dass** die Schicht auf der Basis von kristallisiertem Nickeloxid eine Dicke von mindestens 0,5 nm, bevorzugt zwischen 0,8 und 5 nm, aufweist.

12. Material nach einem der Ansprüche 8 bis 11, **dadurch gekennzeichnet, dass** die Schicht auf der Basis von kristallisiertem Nickeloxid eine Dicke von weniger als 4 nm, bevorzugt weniger als 3 nm und am besten weniger als 2 nm, aufweist.

13. Material nach einem beliebigen der Ansprüche 8 bis 12, **dadurch gekennzeichnet, dass** das Schichtsystem umfasst:
- eine Antireflex-Beschichtung, die unter der metallischen Funktionsschicht auf Silberbasis gelegen ist, die mindestens eine dielektrische Schicht mit stabilisierender Funktion auf Zinkoxidbasis und mindestens eine Schicht auf der Basis von kristallisiertem Nickeloxid umfasst, die in Kontakt mit der dielektrischen Schicht mit stabilisierender Funktion auf Zinkoxidbasis gelegen ist,
- eine metallische Funktionsschicht auf Silberbasis, die in Kontakt mit der Schicht auf Nickeloxidbasis gelegen ist,
- eventuell eine Blocker-Deckschicht,
- eine Antireflexbeschichtung, die über der metallischen Funktionsschicht auf Silberbasis gelegen ist,
- eventuell eine obere Schutzschicht.

14. Material nach einem der Ansprüche 8 bis 13, **dadurch gekennzeichnet, dass** mindestens das Substrat, das mit dem Schichtsystem beschichtet ist, ein gebogenes und/oder vorgespanntes Glas ist.

15. Material nach einem der Ansprüche 8 bis 14, wobei das Substrat aus Glas ist, insbesondere Kalk-Natron-Silikatglas.

## Claims

1. A process for obtaining a material comprising a transparent substrate coated with a stack of thin layers which are deposited by cathode sputtering, optionally assisted by a magnetic field, comprising at least one silver-based functional metal layer and at least two antireflective coatings, each antireflective coating comprising at least one dielectric layer, so that each functional metal layer is positioned between two antireflective coatings, the process comprises the sequence of following stages:
(a) an antireflective coating comprising at least one thin layer based on crystalline nickel oxide is deposited, then
(b) at least one silver-based functional metal layer is deposited above and in contact with the thin layer based on crystalline nickel oxide.

2. The process for obtaining a material as claimed in claim 1, such that, during stage (a):
- a layer capable of inducing crystallization by epitaxy is deposited and then
- a layer based on nickel oxide is deposited above and in contact.

3. The process for obtaining a material as claimed in claim 1 or 2, such that, during stage (a):
- a layer based on crystalline zinc oxide is deposited and then
- a layer based on nickel oxide is deposited above and in contact.

4. The process for obtaining a material as claimed in any one of the preceding claims, such that, during stage (a):
- a layer based on crystalline or noncrystalline nickel oxide is deposited and then
- the thin layer based on crystalline or noncrystalline nickel oxide is subjected to a crystallization heat treatment, before deposition of the silver-based functional metal layer.

5. The process for obtaining a material as claimed in claim 4, such that the crystallization heat treatment is carried out by contributing energy capable of carrying each point of the thin layer based on crystalline or noncrystalline nickel oxide to a temperature of greater than or equal to 300°C.

6. The process for obtaining a material as claimed in any one of the preceding claims, such that all the layers of the stack are produced and the crystallization heat treatment is carried out in the chamber for deposition by cathode sputtering.

7. The process for obtaining a material as claimed in any one of the preceding claims, such that it additionally comprises stage (c) during which the substrate coated with the stack of thin layers is subjected to a heat treatment at a temperature greater than 400°C, preferably 500°C.

8. A material comprising a transparent substrate coated with a stack of thin layers comprising at least one silver-based functional metal layer and at least two antireflective coatings, each antireflective coating comprising at least one dielectric layer, so that each functional metal layer is positioned between two antireflective coatings, **characterized in that** the stack comprises at least one layer based on crystalline nickel oxide located below and in contact with a silver-based functional metal layer comprising several monocrystalline grains oriented so that they have the family of {200} planes parallel to the surface of the substrate.

9. The material as claimed in claim 8, **characterized in that** the antireflective coating located below the silver-based functional layer comprising several monocrystalline grains oriented so that they have the family of {200} planes parallel to the surface of the substrate comprises a dielectric layer capable of generating defects of dome type chosen from layers based on tin and zinc oxide.

10. The material as claimed in either one of claims 8 and 9, **characterized in that** the antireflective coating located below the silver-based functional layer comprising several monocrystalline grains oriented so that they have the family of {200} planes parallel to the surface of the substrate comprises a dielectric layer having a stabilizing function based on zinc oxide located below and in contact with the layer based on crystalline nickel oxide.

11. The material as claimed in any one of claims 8 to 10, **characterized in that** the layer based on crystalline nickel oxide exhibits a thickness of at least 0.5 nm, preferably of between 0.8 and 5 nm.

12. The material as claimed in any one of claims 8 to 11, **characterized in that** the layer based on crystalline nickel oxide exhibits a thickness of less than 4 nm, preferably of less than 3 nm and better still of less than 2 nm.

13. The material as claimed in any one of claims 8 to 12, **characterized in that** the stack comprises:
- an antireflective coating located below the silver-based functional metal layer comprising at least one dielectric layer having a stabilizing function based on zinc oxide and at least one layer based on crystalline nickel oxide located in contact with the dielectric layer having a stabilizing function based on zinc oxide,
- a silver-based functional metal layer located in contact with the layer based on nickel oxide,
- optionally a blocking overlayer,
- an antireflective coating located above the silver-based functional metal layer,
- optionally an upper protective layer.

14. The material as claimed in any one of claims 8 to 13, **characterized in that** at least the substrate coated with the stack is a bent and/or tempered glass.

15. The material as claimed in any one of claims 8 to 14, such that the substrate is made of glass, in particular soda-lime-silica glass.
